# EUROPEAN PATENT APPLICATION

(11) **EP 2 927 933 A1**
(43) Date of publication of application: **07.10.2015**
(21) Application number: 13858133.5
(22) Date of filing: 26.11.2013
(51) Int. Cl.: H01L 21/02, B23K 20/00

(54) **NORMAL TEMPERATURE BONDING DEVICE, WAFER HAVING NORMAL TEMPERATURE BONDING DEVICE, AND NORMAL TEMPERATURE BONDING METHOD**

(30) Priority: 27.11.2012 JP 2012258771
(71) Applicant: Mitsubishi Heavy Industries, Ltd., Tokyo 108-8215 (JP)
(72) Inventor: GOTO Takayuki, Minato-ku, Tokyo 108-8215 (JP); TSUTSUMI Keiichiro, Minato-ku, Tokyo 108-8215 (JP); TSUNO Takeshi, Minato-ku, Tokyo 108-8215 (JP); KINOUCHI Masato, Minato-ku, Tokyo 108-8215 (JP); IDE Kensuke, Minato-ku, Tokyo 108-8215 (JP)
(74) Representative: Henkel, Breuer & Partner
(86) International application number: PCT/JP2013/081807
(87) International publication number: WO 2014/084217

(57) **Abstract**

A room-temperature bonded device has a first substrate having a first surface and a second substrate having a second surface to be bonded to the first surface. In the bonding of the first surface and the second surface, one of the first surface and the second surface contains an inorganic material such as silicon, SiO₂, GaN and LiTaO₃. The other of the first surface and the second surface contains an inorganic material such as silicon, SiO₂, quartz and Au. The inorganic materials of the first surface and the second surface may be same or may be different.

## Description

### Technical Field

The present invention relates to a room-temperature bonded device, a wafer having the room-temperature bonded device, and a room-temperature bonding method.

### Background Art

A technique of bonding a plurality of substrates is known. For example, the technique is used for semiconductor devices such as a MEMS (Micro Electro Mechanical Systems) device and a three-dimensional LSI (Large Scale Integration) device.

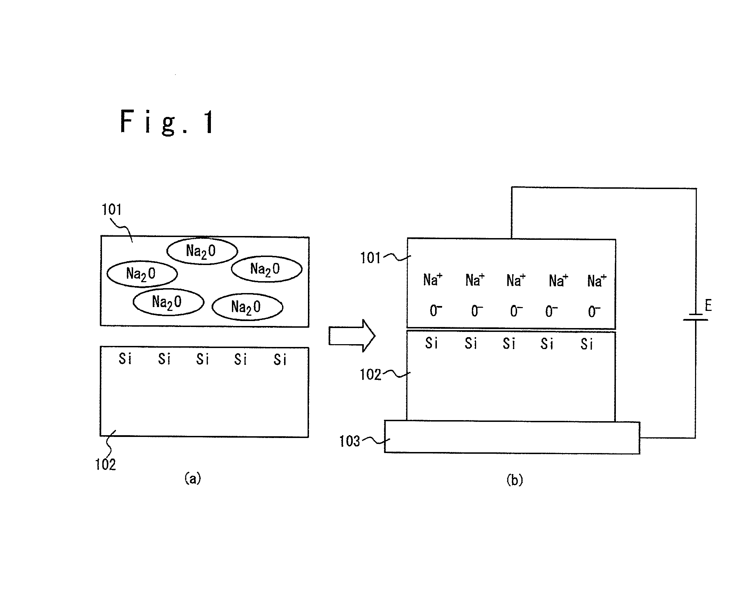

In a semiconductor acceleration sensor disclosed in, for example, Japanese Patent No. 3,678,090 (Patent Literature 1), a sensing element formed of silicon and a lower cap formed of heat-resistant glass are bonded by anode bonding. FIG. 1 is a diagram schematically showing the anode bonding. As shown in (a) of FIG. 1, first, the surface of a glass 101 and the surface of a silicon plate 102 are polished. Next, as shown in (b) of FIG. 1, the polished surface of the glass 101 and the polished surface of the silicon plate 102 are faced to and brought into contact with each other, and heat treatment is carried out for 2 to 3 hours at 300 to 400 °C by a heater 103. At that time, a voltage E is applied between the glass 101 and the silicon plate 102. Thus, Na⁺ ions in the glass 101 are attracted to a negative voltage to leave from the boundary of the glass 101 and the silicon plate 102. Therefore, the covalent bonding of O⁻ ions in the glass 101 and Si atoms in the silicon plate 102 occurs in the boundary. As a result, the glass 101 and the silicon plate 102 are bonded. This anode bonding has various problems such as a limitation of bonded material, a time for heating and cooling, and thermal warp and thermal stress due to the heating.

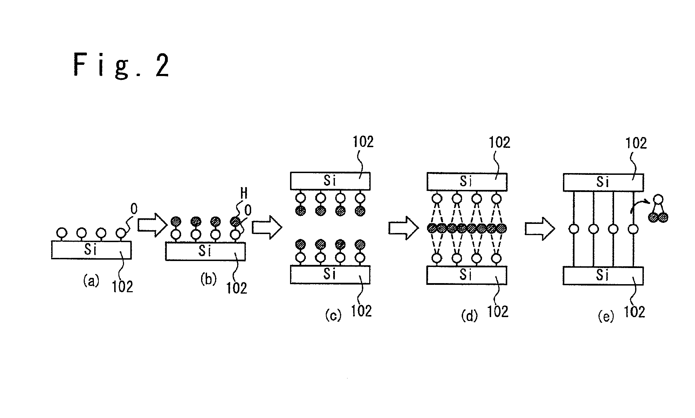

Also, in a bonding method disclosed in Japanese Patent 3,751,972 (Patent Literature 2: corresponding to U.S. application publication (US 2007/110917A1)), bonded objects, each of which is any of Si, SiO₂, and glass, are bonded by a plasma activation bonding method. FIG. 2 is a diagram schematically showing the plasma activation bonding method. First, as shown in (a) of FIG. 2, the surface of a silicon substrate 102 is subjected to oxygen plasma processing so as to make the surface hydrophilic. Active oxygen atoms adhere to the surface. Next, as shown in (b) of FIG. 2, the surface of the silicon substrate 102 is treated with pure water to adhere hydroxyl groups to the surface. Subsequently, as shown in (c) and (d) of FIG. 2, the two silicon substrates are bonded in such a manner that the surfaces of the two substrates having the hydroxyl groups are faced to each other. In this case, temporary weak bonding occurs by the hydrogen bonding through water molecules. After that, as shown in € of FIG. 2, a thermal treatment is carried out for 2 to 10 hours at the temperature of 200 °C in that bonding condition. Thus, the water is removed so as to produce strong bonding. In this plasma activation bonding method, there are problems that the bonding material is limited to a Si-based material, that a void is easy to generate in the binding boundary because hydrogen cannot be completely removed, and that a heat warp and a thermal stress due to heating occur.

Also, as another technique which bonds a plurality of substrates, the room-temperature bonding method is known. For example, the room-temperature bonding apparatus is disclosed in Japanese Patent No. 3,970,304 (Patent Literature 3). The room-temperature bonding apparatus is provided with a bonding chamber, an upper-side stage, a carriage, an elastic guide, a positioning stage, a first mechanism, a second mechanism and a carriage support table. The bonding chamber generates a vacuum ambience used for the room-temperature bonding of an upper-side substrate and a lower-side substrate. The upper-side stage is disposed in the bonding chamber to support the upper-side substrate in the vacuum ambience. The carriage is disposed in the bonding chamber to support the lower-side substrate in the vacuum ambience. The elastic guide is coupled unitarily to the carriage. The positioning stage is disposed in the bonding chamber to support the elastic guide to be movable in a horizontal direction. The first mechanism drives the elastic guide to move the carriage to the horizontal direction. The second mechanism drives the upper-side stage to move to up and down directions perpendicular to the horizontal direction. The carriage support table is disposed in the bonding chamber to support the carriage in a direction to which the upper-side stage moves, when the lower-side substrate and the upper-side substrate are subjected to the pressure bonding. The elastic guide supports the carriage so as for the carriage not to contact the carriage support table when the lower-side substrate and the upper-side substrate are not brought into contact. The elastic guide elastically transforms for the carriage to contact the carriage support table when the lower-side substrate and the upper-side substrate are to be subjected to the pressure bonding.

A bonding technique is required which can enable various combinations of materials as components of a functional device to be bonded. Also, the bonding technique is required which can enable different kinds of materials to be bonded without generating any inner stress in the bonding boundary. Moreover, the bonding technique is required which can prevent exposure to a high temperature environment of electronic and mechanical devices formed on a material in the bonding process. Moreover, it is required to provide MEMS and semiconductor devices which are configured from the bonding structures of various materials, and have high operational reliabilities and yields.

### Citation List

[Patent Literature 1] Japanese patent No. 3,678,090
[Patent Literature 2] Japanese patent No. 3,751,972
[Patent literature 3] Japanese patent No. 3,970,304

### Summary of the Invention

An object of the present invention is to provide a bonding technique which allows various combinations of materials as components of a functional device to be bonded.

Another object of the present invention, other objects, and an advantage except for the other object can be easily understood by the following description and the attached drawings.

The room-temperature bonded device of the present invention includes a first substrate having a first surface and a second substrate having a second surface which is subjected to a room-temperature bonding with the first surface. In the bonding of the first surface and the second surface, the first surface contains one material selected from the group consisting of Si, SiO₂, GaN, LiTaO₃, LiNbO₃, Cu, glass, quartz, sapphire, YAG, Al, AlN, Au, Ag, AlCu, C, Cr, GaAs, GaP, Ge, InGaP, Mo, SiC, SiN, SiOC, SiON, Ta, Ti and TiO₂. Also, the second surface contains one material selected from the group consisting of Si, SiO₂, glass, quartz, Au, LiTaO₃, sapphire, GaN, the GaAs, LiNbO₃, SiN, InP, Cu, SiC, Ag, Al, AlN, Ge, La, MgO, Pt, Ru, W, C, Ni, Mo, YAG, InGaAs, Ga₂O₃, spinel, AlCu, Cr, Ta, ZnO, Ti, RIG, ITO, AuSn, GaP, SiOC, SiON and TiO₂.

In case of bonding of the first surface and the second surface in the above-mentioned room-temperature bonded device, one of the first surface and the second surface contains an n^{th} one-side material and the other contain an n^{th} other-side material, and n is either of the integers of 1 or 28. In case of n = 1, the first one-side material contains Si, the first other-side material contains the material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo and YAG. In case of n = 2, the second one-side material contains SiO₂, and the second other-side material contains the material selected from the group consisting of SiO₂, LiNbO₃, sapphire, SiN, glass, quartz, LiTaO₃, Al, C, InGaAs, InP, SiC, YAG, GaN, Ag and MgO. In case of n = 3, the third one-side material contains GaN, and the third other-side material contains the material selected from the group consisting of AlN, GaN, Ga₂O₃, Mo, SiC, sapphire, spinel, W, SiN and YAG. In case of n = 4, the fourth one-side material contains LiTaO₃, and the fourth other-side material contains the material selected from the group consisting of sapphire, LiTaO₃, SiN, glass, quartz, LiNbO₃, Cu, ZnO, C and spinel. In case of n = 5, the fifth one-side material contains LiNbO₃, and the fifth other-side material contains the material selected from the group consisting of LiNbO₃, Au, Ti, glass and quartz. In case of n = 6, the sixth one-side material contains Cu, and the sixth other-side material contains the material selected from the group consisting of Cu, Al, AlN, SiN, Ti, Au, AlCu, Cr and Ta. In case of n = 7, the seventh one-side material contains glass or quartz, and the seventh other-side material contains the material selected from the group consisting of glass, quartz, GaAs, RIG, SiN and MgO. In case of n = 8, the eighth one-side material contains sapphire, and the eighth other-side material contains the material selected from the group consisting of sapphire, YAG, ZnO, RIG and ITO. In case of n = 9, the ninth one-side material contains YAG and the ninth other-side material contains the material selected from the group consisting of YAG, Al, ITO and ZnO. In case of n = 10, the tenth one-side material contains Al and the tenth other-side material contains the material selected from the group consisting of Al, AlN and Ge. In case of n = 11, the eleventh one-side material contains AlN, and the eleventh other-side material contains the material selected from the group consisting of AlN, SiC and W. In case of n = 12, the twelfth one-side material contains Au, and the twelfth other-side material contains the material selected from the group consisting of Au, AuSn, InP and Al sapphire. In case of n = 13, the thirteenth one-side material contains Ag and the thirteenth other-side material contains Ag. In case of n = 14, the fourteenth one-side material contains AlCu and the fourteenth other-side material contains AlCu. In case of n = 15, the fifteenth one-side material contains C and the fifteenth other-side material contains C. In case of n = 16, the sixteenth one-side material contains Cr and the sixteenth other-side material contains Cr. In case of n = 17, the seventeenth one-side material contains GaAs, and the seventeenth other-side material contains GaAs or InP. In case of n = 18, the eighteenth one-side material contains GaP and the eighteenth other-side material contains GaP. In case of n = 19, the nineteenth one-side material contains Ge and the nineteenth other-side material contains Ge. In case of n = 20, the twentieth one-side material contains InGaP and the twentieth other-side material contains InGaP. In case of n = 21, the twenty-first one-side material contains Mo and the twenty-first other-side material contains Mo or W. In case of n = 22, the twenty-second one-side material contains SiC and the twenty-second other-side material contains SiC. In case of n = 23, the twenty-third one-side material contains SiN and the twenty-third other-side material contains SiN. In case of n = 24, the twenty-fourth one-side material contains SiOC and the twenty-fourth other-side material contains SiOC. In case of n = 25, the twenty-fifth one-side material contains SiON and the twenty-fifth other-side material contains SiON. In case of n = 26, the twenty-sixth one-side material contains Ta and the twenty-sixth other-side material contains Ta. In case of n = 27, the twenty-seventh one-side material contains Ti and the twenty-seventh other-side material contains Ti. In case of n = 28, the twenty-eighth one-side material contains TiO₂ and the twenty-eighth other-side material contains TiO₂.

It is desirable that the above-mentioned room-temperature bonded device further has a third substrate having a third surface. The second substrate further has a fourth surface opposite to the second surface and bonded with the third surface. In the bonding of the third surface and the fourth surface, desirably, one of the third surface and the fourth surface contains an n^{th} one-side material, and the other contains an n^{th} other-side material.

A bonding wafer has the room-temperature bonded device of the present invention is provided with the room-temperature bonded device according to each of the above paragraphs. A first wafer is common to a plurality of the room-temperature bonded devices, and has the first substrates of the plurality of room-temperature bonded devices. A second wafer is common to the plurality of room-temperature bonded devices and the second substrates of the plurality of room-temperature bonded devices.

A bonding method of on the present invention includes: providing a room-temperature bonding apparatus which comprises: a vacuum container, a first holding mechanism disposed in the vacuum container, a second holding mechanism disposed in the vacuum container, a beam source disposed in the vacuum container to emit an activation beam, and a pressure bonding mechanism disposed in the vacuum container; holding a first substrate by a first holding mechanism and a second substrate by the second holding mechanism; irradiating the activation beam from the beam source to bonding surfaces of the first substrate and the second substrate; and bonding the first substrate and the second substrate by facing the bonding surfaces of the first substrate and the second substrate which are irradiated with the activation beam by the pressure bonding mechanism. The first substrate has a first surface, and the second substrate has a second surface to be bonded to the first surface. In the bonding of the first surface and the second surface, the first surface contains one material selected from the group consisting of Si, SiO₂, GaN, LiTaO₃, LiNbO₃, Cu, glass, quartz, sapphire, YAG, Al, AlN, Au, Ag, AlCu, C, Cr, GaAs, GaP, Ge, InGaP, Mo, SiC, SiN, SiOC, SiON, Ta, Ti and TiO₂. The second surface contains one material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo, YAG, InGaAs, Ga₂O₃, spinel, AlCu, Cr, Ta, ZnO, Ti, RIG, ITO, AuSn, GaP, SiOC, SiON and TiO₂.

It is desirable that in the bonding of the first surface and the second surface in the above-mentioned room-temperature bonding method, one of the first surface and the second surface contains an n^{th} one-side material and the other contain an n^{th} other-side material. Here, n is any of the integers of 1 to 28. In case of n = 1, the first one-side material contains Si, and the first other-side material contains the material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo and YAG. In case of n = 2, the second one-side material contains SiO₂, and the second other-side material contains the material selected from the group consisting of SiO₂, LiNbO₃, sapphire, SiN, glass, quartz, LiTaO₃, Al, C, InGaAs, InP, SiC, YAG, GaN, Ag and MgO. In case of n = 3, the third one-side material contains GaN, and the third other-side material contains the material selected from the group consisting of AlN, GaN, Ga₂O₃, Mo, SiC, sapphire, spinel, W, SiN and YAG. In case of n = 4, the fourth one-side material contains LiTaO₃, and the fourth other-side material contains the material selected from the group consisting of sapphire, LiTaO₃, SiN, glass, quartz, LiNbO₃, Cu, ZnO, C and spinel. In case of n = 5, the fifth one-side material contains LiNbO₃, and the fifth other-side material contains the material selected from the group consisting of LiNbO₃, Au, Ti, glass and quartz. In case of n = 6, the sixth one-side material contains Cu, and the sixth other-side material contains the material selected from the group consisting of Cu, Al, AlN, SiN, Ti, Au, AlCu, Cr and Ta. In case of n = 7, the seventh one-side material contains glass or quartz, and the seventh other-side material contains the material selected from the group consisting of glass, quartz, GaAs, RIG, SiN and MgO. In case of n = 8, the eighth one-side material contains sapphire, and the eighth other-side material contains the material selected from the group consisting of sapphire, YAG, ZnO, RIG and ITO. In case of n = 9, the ninth one-side material contains YAG, and the ninth other-side material contains the material selected from the group consisting of YAG, Al, ITO and ZnO. In case of n = 10, the tenth one-side material contains Al, and the tenth other-side material contains the material selected from the group consisting of Al, AlN and Ge. In case of n = 11, the eleventh one-side material contains AlN, and the eleventh other-side material contains the material selected from the group consisting of AlN, SiC and W. In case of n = 12, the twelfth one-side material contains Au, and the twelfth other-side material contains the material selected from the group consisting of Au, AuSn, InP and Al sapphire. In case of n = 13, the thirteenth one-side material contains Ag and the thirteenth other-side material contains Ag. In case of n = 14, the fourteenth one-side material contains AlCu and the fourteenth other-side material contains AlCu. In case of n = 15, the fifteenth one-side material contains C, and the fifteenth other-side material contains C. In case of n = 16, the sixteenth one-side material contains Cr, and the sixteenth other-side material contains Cr. In case of n = 17, the seventeenth one-side material contains GaAs, and the seventeenth other-side material contains GaAs or InP. In case of n = 18, the eighteenth one-side material contains GaP, and the eighteenth other-side material contains GaP. In case of n = 19, the nineteenth one-side material contains Ge, and the nineteenth other-side material contains Ge. In case of n = 20, the twentieth one-side material contains InGaP, and the twentieth other-side material contains InGaP. In case of n = 21, the twenty-first one-side material contains Mo, and the twenty-first other-side material contains Mo or W. In case of n = 22, the twenty-second one-side material contains SiC, and the twenty-second other-side material contains SiC. In case of n = 23, the twenty-third one-side material contains SiN, and the twenty-third other-side material contains SiN. In case of n = 24, the twenty-fourth one-side material contains SiOC, and the twenty-fourth other-side material contains SiOC. In case of n = 25, the twenty-fifth one-side material contains SiON, and the twenty-fifth other-side material contains SiON. In case of n = 26, the twenty-sixth one-side material contains Ta, and the twenty-sixth other-side material contains Ta. In case of n = 27, the twenty-seventh one-side material contains Ti, and the twenty-seventh other-side material contains Ti. In case of n = 28, the twenty-eighth one-side material contains TiO₂, and the twenty-eighth other-side material contains TiO₂. In such a room-temperature bonding method, because the room-temperature bonding is used so that a warp due to heating does not occur, the yield can be improved. Also, in the room-temperature bonding, because the heating and the cooling time are unnecessary, it is possible to improve the productivity. Also, in the room-temperature bonding, various options of the materials can be provided and the application field can be extended.

In the present invention, various combinations of materials as the components of the functional device can be bonded.

### Brief Description of the Drawings

FIG. 1 is a diagram schematically showing a conventional anode bonding method.
FIG. 2 is a diagram schematically showing a conventional plasma activation bonding method.
FIG. 3A is a diagram schematically showing the overview of a first room-temperature bonding method according to an embodiment.
FIG. 3B is a diagram schematically showing the overview of a second room-temperature bonding method according to the embodiment.
FIG. 3C is a diagram schematically showing the overview of a third room-temperature bonding method according to the embodiment.
FIG. 4A is a table showing materials that can be used for the room-temperature bonding according to the embodiment.
FIG. 4B is a table showing materials that can be used for the room-temperature bonding according to the embodiment.
FIG. 4C is a table showing materials that can be used for the room-temperature bonding according to the embodiment.
FIG. 5 is a sectional view showing the configuration of the room-temperature bonding apparatus according to the embodiment.
FIG. 6 is another sectional view showing the configuration of the room-temperature bonding apparatus according to the embodiment.
FIG. 7A is a sectional view showing an example of the room-temperature bonded device in an example 1.
FIG. 7B is a sectional view showing an example of the room-temperature bonded device in the example 1.
FIG. 8 is a sectional view showing an example of the room-temperature bonded device in an example 2.
FIG. 9 is a sectional view showing another example of the room-temperature bonded device in the example 2.

### Description of embodiments

Hereinafter, with reference to the attached drawings, embodiments of a room-temperature bonded device, a wafer having the room-temperature bonded device, and a room-temperature bonding method according to the present invention will be described.

In an embodiment, a room-temperature bonding method is used as a technique of bonding a plurality of substrates (wafers). In this case, the following three cases are considered as the room-temperature bonding method.

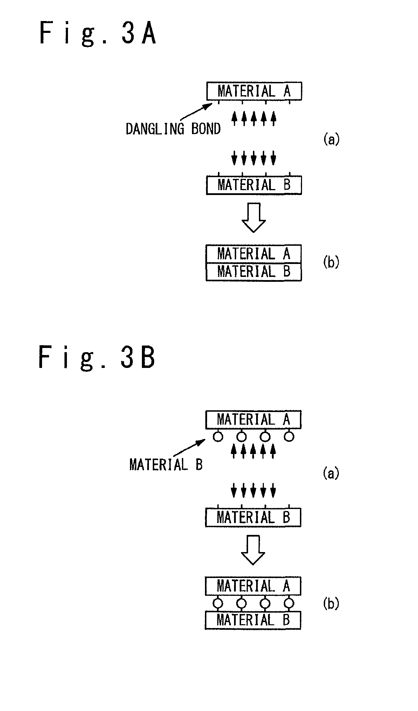

FIG. 3A is a diagram schematically showing the overview of a first room-temperature bonding method according to the present embodiment. In the first room-temperature bonding method, as shown in (a) of FIG. 3A, a high-speed particle beam of an inactive element such as an ion beam and an atomic beam is irradiated to the surfaces of a material A and a material B as bonding objects which are arranged in a vacuum condition. According to the collision of the particles of the high-speed particle beam, an oxide film layer and an impurity layer are sputtered and are removed from the surfaces of the material A and material B. The surfaces of the materials A and B are activated, and non-combined hands of the surface atom which are called dangling bonds appear in those surfaces. After that, as shown in (b) of FIG. 3A, when the surface of the material A and the surface of material B in this state are brought into contact with each other, the non-combined hands are coupled so that the materials A and B become a stable state in energy. Thus, the material A and the material B as the bonding objects are bonded, and the room-temperature bonding method completes.

FIG. 3B is a diagram schematically showing the overview of a second room-temperature bonding method according to the present embodiment. In the second room-temperature bonding method, as shown in (b) of FIG. 3B, a high-speed particle beam is irradiated to the surfaces of the material A and the material B as the bonding objects which are arranged in the vacuum state. According to the collision of the particles of the high-speed particle beam, an oxide film layer and an impurity layer are sputtered and are removed from the surfaces of the material A and the material B. At this time, the material B on one side is sputtered and an adhesion layer formed of the material B is deposited on the bonding surface of the material A on the other side. The surface of the adhesion layer is in the active condition. On the other hand, the surface of the material A is activated and the non-combined hands of the surface atoms which are called dangling bonds appear in the surface. After that, as shown in (b) of FIG. 3B, the surface of the material A and the surface of material B in this state are brought into contact with each other, so that the material A and the material B as the bonding objects are bonded through the adhesion layer of the material B in the active condition, and the room-temperature bonding completes. Note that the material A itself on the one side may be sputtered and deposited as an adhesion layer formed of the material A on the bonding surface of the material B on the other side. In this case, the material A and the material B as the bonding objects are bonded through the adhesion layer of the material B and the adhesion layer of the material A which are in the active condition.

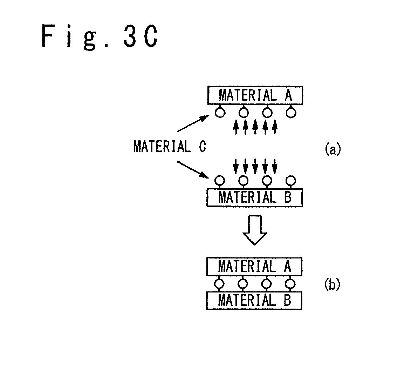

FIG. 3C is a diagram schematically showing the overview of a third room-temperature bonding method according to the present embodiment. In the third room-temperature bonding method, as shown in (a) of FIG. 3C, a high-speed particle beam is irradiated to the surface of the material A and the material B as the bonding objects which are arranged in the vacuum condition. According to the collision of the particles of the high-speed particle beam, an oxide film layer and an impurity layer are sputtered and removed from the surfaces of the material A and material B. At that time, the high-speed particle beam is irradiated to the surface of a material C (target) of a different kind, to sputter the material C such that the material C is deposited on the surfaces of the material A and material B. The surface of the material C is in the active condition. After that, as shown in (b) of FIG. 3C, the surface of the material A and the surface of material B are brought into contact with each other so that the material A and the material B as the bonding objects are bonded through an intermediate layer of the activated material C, and the room-temperature bonding method completes.

Here, in case where an electronic device and metal wiring lines are previously formed inside the material A and the material B, and one device is completed by bonding the material A and the material B, either of the above first to third room-temperature bonding methods can be used. Even if any of the room-temperature bonding methods is used, the room-temperature bonded device is formed by using the room-temperature bonding method in which heating is not necessary. Therefore, the warp and the stress due to the heating do not occur. Therefore, it is possible to improve the yield. Also, because a heating time and a cooling time are unnecessary in the room-temperature bonding method, it is possible to improve the productivity. Also, because various kinds of materials can be bonded in the room-temperature bonding, the degrees of freedom of selection of materials can be spread and the application field can be extended.

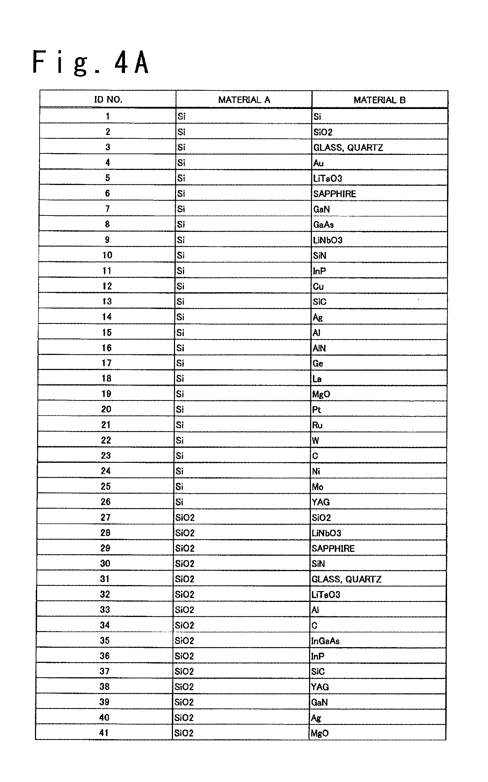

When a plurality of substrates (wafers) are bonded by the room-temperature bonding method, for example, inorganic materials such as a semiconductor material, an insulator material, a dielectric material, a magnetic substance material, and a metal material are exemplified as the candidates of the materials A and B in FIG. 3A to FIG. 3C. FIG. 4A to FIG. 4C are tables showing the materials that can be used for the room-temperature bonding methods according to the present embodiment. It has been confirmed by the inventors through the room-temperature bonding experiments (FIG. 3A to FIG. 3C) that the materials specified in FIG. 4A to FIG. 4C can be bonded actually. As shown in FIG. 4A to FIG. 4C, in case of bonding of the surface of the material A and the surface of the material B, either of the material A and the material B contains the following n^{th} one-side material and the other contains the following n^{th} other-side material. Here, n is either of the integers of 1 to 28.

Referring to FIG. 4A, when the material A (the first one-side material) contains, for example, Si, the material B (the first other-side material) contains the material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo and YAG (Yttrium Aluminum Garnet) (ID Nos. 1 to 26).

Also, when the material A (the second one-side material) contains SiO₂, the material B (the second other-side material) contains the material selected from the group consisting of SiO₂, LiNbO₃, sapphire, SiN, glass, quartz, LiTaO₃, Al, C, InGaAs, InP, SiC, YAG, GaN, Ag and MgO (ID Nos. 27 to 41).

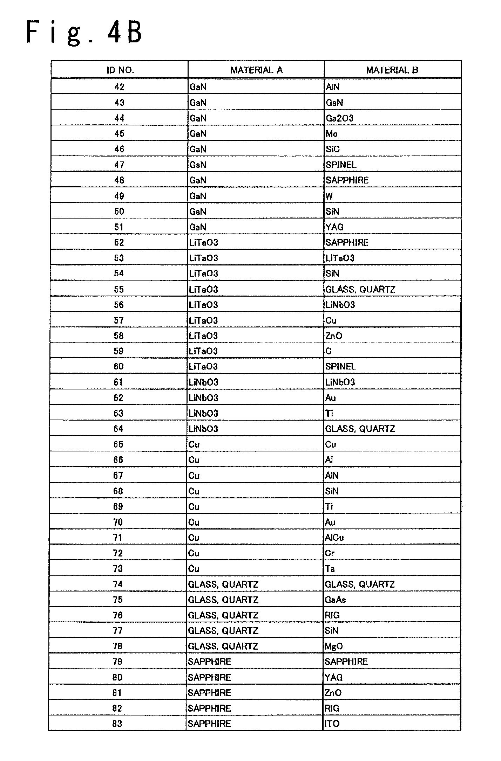

Referring to FIG. 4B, when the material A (the third one-side material) contains GaN, the material B (the third other-side material) contains the material selected from the group consisting of AlN, GaN, Ga₂O₃, Mo, SiC, sapphire, spinel, W, SiN and YAG (ID Nos. 42 to 51). When the material A (the fourth one-side material) contains LiTaO₃, the material B (the fourth other-side material) contains the material selected from the group consisting of sapphire, LiTaO₃, SiN, glass, quartz, LiNbO₃, Cu, ZnO, C and spinel (ID Nos. 52 to 60). When the material A (the fifth one-side material) contains LiNbO₃, the material B (the fifth other-side material) contains the material selected from the group consisting of LiNbO₃, Au, Ti, glass and quartz (ID Nos. 61 to 64). When the material A (the sixth one-side material) contains Cu, the material B (the sixth other-side material) contains the material selected from the group consisting of Cu, Al, AlN, SiN, Ti, Au, AlCu, Cr and Ta (ID Nos. 65 to 73). When the material A (the seventh one-side material) contains glass or quartz, the material B (the seventh other-side material) contains the material selected from the group consisting of glass, quartz, GaAs, RIG (Rare-earth Iron Garnet), SiN and MgO (ID Nos. 74 to 78). When the material A (the eighth one-side material) contains sapphire, the material B (the eighth other-side material) contains the material selected from the group consisting of sapphire, YAG, ZnO, RIG and ITO (Indium Tin Oxide) (ID Nos. 79 to 83).

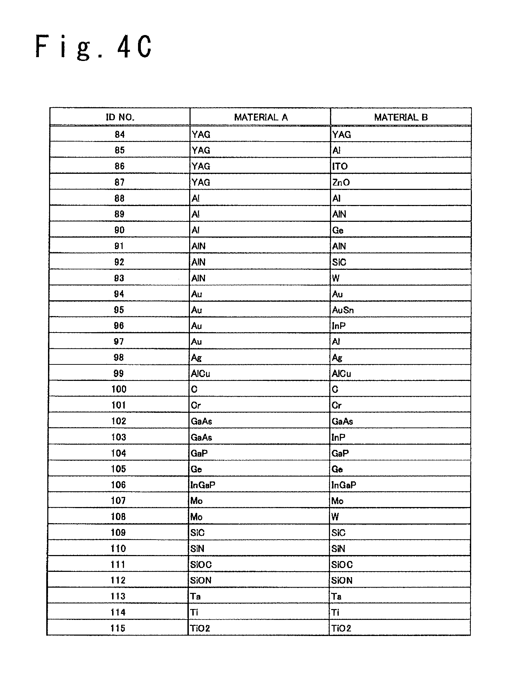

Referring to FIG. 4C, when the material A (the ninth one-side material) contains YAG, the material B (the ninth other-side material) contains the material selected from the group consisting of YAG, Al, ITO and ZnO (ID Nos. 84 to 87). When the material A (the tenth one-side material) contains Al, the material B (the tenth other-side material) contains the material selected from the group consisting of Al, AlN and Ge (ID No. 88 to 90). When the material A (the eleventh one-side material) contains AlN, the material B (the eleventh other-side material) contains the material selected from the group consisting of AlN, SiC and W (ID Nos. 91 to 93). When the material A (the twelfth one-side material) contains Au, the material B (the twelfth other-side material) contains the material selected from the group consisting of Au, AuSn, InP and Al sapphire (ID Nos. 94 to 97). When the material A (the thirteenth one-side material) contains Ag, the material B (the thirteenth other-side material) contains Ag (ID No. 98). When the material A (the fourteenth one-side material) contains AlCu, the material B (the fourteenth other-side material) contains AlCu (ID No. 99). When the material A (the fifteenth one-side material) contains C, the material B (the fifteenth other-side material) contains C (ID No. 100). When the material A (the sixteenth one-side material) contains Cr, the material B (the sixteenth other-side material) contains Cr (ID No. 101). When the material A (the seventeenth one-side material) contains GaAs, the material B (the seventeenth other-side material) contains GaAs or InP (ID Nos. 102 to 103). When the material A (the eighteenth one-side material) contains GaP, the material B (the eighteenth other-side material) contains GaP (ID No. 104). When the material A (the nineteenth one-side material) contains Ge, the material B (the nineteenth other-side material) contains Ge (ID No. 105). When the material A (the twentieth one-side material) contains InGaP, the material B (the twentieth other-side material) contains InGaP (ID No. 106). When the material A (the twenty-first one-side material) contains Mo, the material B (the twenty-first other-side material) contains Mo or W (ID Nos. 107 to 108). When the material A (the twenty-second one-side material) contains SiC, the material B (the twenty-second other-side material) contains SiC (ID No. 109). When the material A (the twenty-third one-side material) contains SiN, the material B (the twenty-third other-side material) contains SiN (ID No. 110). When the material A (the twenty-fourth one-side material) contains SiOC, the material B (the twenty-fourth other-side material) contains SiOC (ID No. 111). When the material A (the twenty-fifth one-side material) contains SiON, the material B (the twenty-fifth other-side material) contains SiON (ID No. 112). When the material A (the twenty-sixth one-side material) contains Ta, the material B (the twenty-sixth other-side material) contains Ta (ID No. 113). When the material A (the twenty-seventh one-side material) contains Ti, the material B (the twenty-seventh other-side material) contains Ti (ID No. 114). When the material A (the twenty-eighth one-side material) contains TiO₂, the material B (the twenty-eighth other-side material) contains TiO₂ (ID No. 115).

115 sets are shown as sets of the material A and the material B in the above-mentioned FIG. 4A to FIG. 4C. These can be bonded by at least one of the room-temperature bonding methods. Note that the sets of the materials are not limited to FIG. 4A to FIG. 4C.

From the above experiment results (the contents shown in FIG. 4A to FIG. 4C) of the room-temperature bonding, it could be considered that the bonding of the surfaces of the following materials A and B is possible by using either of the room-temperature bonding methods shown in FIG. 3A to FIG. 3C. The surface of the material A contains the material selected from the group consisting of Si, SiO₂, GaN, LiTaO₃, LiNbO₃, Cu, glass, quartz, sapphire, YAG, Al, AlN, Au, Ag, AlCu, C, Cr, GaAs, GaP, Ge, InGaP, Mo, SiC, SiN, SiOC, SiON, Ta, Ti and TiO₂. Also, the surface of the material B contains the material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo, YAG, InGaAs, Ga₂O₃, spinel, AlCu, Cr, Ta, ZnO, Ti, RIG, ITO, AuSn, GaP, SiOC, SiON and TiO₂. The kinds of the material may be opposite about the material A and the material B.

Note that in the room-temperature bonding, the materials A may be used and the materials B may be used. Also, from the experiment result of each of the above room-temperature bonding methods, it could be considered that the inorganic materials of substantially all kinds can be subjected to the room-temperature bonding by using the above-mentioned room-temperature bonding method.

Next, the room-temperature bonding apparatus which carries out the room-temperature bonding in the present embodiment will be described.

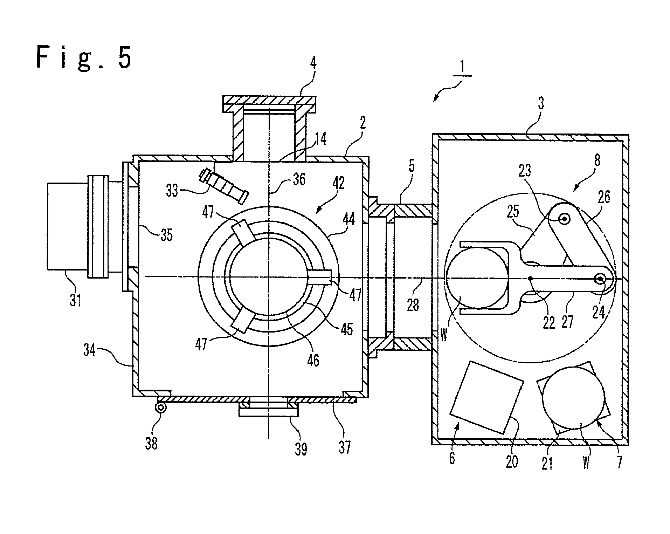

FIG. 5 is a (horizontal) sectional view showing the structure of the room-temperature bonding apparatus according to the present embodiment. The room-temperature bonding apparatus 1 is provided with a bonding chamber 2 and a load lock chamber 3. The bonding chamber 2 and the load lock chamber 3 are the vacuum containers which shield the inside from the environment. Moreover, the room-temperature bonding apparatus 1 is provided with a gate valve 5. The gate valve 5 is interposed between the bonding chamber 2 and the load lock chamber 3. The gate valve 5 is closes down or opens the gate which connects the inside of the bonding chamber 2 and the inside of the load lock chamber 3.

The load lock chamber 3 is provided with a first cartridge table 6, a second cartridge table 7 and a conveyance unit 8 thereinside. A first cartridge 20 is arranged on the first cartridge table 6. The first cartridge 20 is used to load a wafer (substrate). A second cartridge 21 is arranged on the second cartridge table 7. The second cartridge 21 is used to load a wafer (substrate). At this time, there may be a plurality of cartridge tables 6 and 7, and a plurality of cartridge 20 and 21. Moreover, the load lock chamber 3 is provided with a vacuum pump (not shown). A gas is exhausted from the inside of the load lock chamber 3 by the vacuum pump. The lid can close the gate which connects the outside of the load lock chamber 3 and the inside thereof and open the gate to the atmosphere. The first cartridge 20 and the second cartridge 21 are taken into and out from the load lock chamber 3 through the lid.

The conveyance unit 8 is provided with a first arm 25, a second arm 26 and a third arm 27. The first arm 25, the second arm 26 and the third arm 27 are formed to have a stick shape, respectively. The first arm 25 is supported by a floor plate of the load lock chamber 3 to be rotatable around a rotation axis 22 at a first node of one end of the first arm 25. The second arm 26 is supported to a second node between the first arm 25 and the second arm 26 to be rotatable around a rotation axis 23. The third arm 27 is supported to a third node between the second arm 26 and the third arm 27 to be rotatable around a rotation axis 24. Each rotation axis is parallel to a vertical direction. The third arm 27 has nails formed in an end opposite to an end connected to the third node. The nails are used to hold the wafer w, the cartridge 20 or the cartridge 21.

The conveyance unit 8 is further provided with an elevating and lowering mechanism and an extensible mechanism (not shown). The elevating and lowering mechanism elevates and lowers the first arm 25 in response to an operation of a user to elevate and lower the wafer w, the cartridge 20 or the cartridge 21 held by the nails. The extensible mechanism controls the first node, the second node and the third node so that the third arm 27 moves in a direction parallel to the longitudinal direction of the third arm 27. The conveyance unit 8 is used to convey the wafer w arranged on the first cartridge 20 or the second cartridge 21 to the bonding chamber 2 through the gate valve 5 and to convey the wafer w arranged in the bonding chamber 2 through the gate valve 5 to the first cartridge 20 or the second cartridge 21.

The bonding chamber 2 is provided with a vacuum pump 31, a high-speed atom beam source 4 and an electron gun 33. The bonding chamber 2 has an exhaust port 35 formed in a part of a wall 34 which forms a container. The vacuum pump 31 is arranged outside the bonding chamber 2 and exhausts gas from the inside of the bonding chamber 2 through an exhaust port 35. The high-speed atom beam source 4 is arranged to turn to an irradiation direction 36 and emits an accelerated high-speed atom beam to the irradiation direction 36. The high-speed atom beam is exemplified by a neuter argon atom beam. The electron gun 33 is arranged to turn to an object to which the high-speed atom beam is irradiated by the high-speed atom beam source 4, and is possible to emit accelerated electrons to the object.

The wall 34 has a door 37 formed in a part thereof. The door 37 is provided with a hinge 38. The hinge 38 supports the door 37 to be rotatable to wall 34. Moreover, the wall 34 has a window 39 formed in a part thereof. The window 39 is formed of a material which does not transmit gas and which transmits a visible light. The window 39 is arranged so that the user can see the object to which electrically charged particles are irradiated from the high-speed atom beam source 4, or a bonding state from outside the bonding chamber 2.

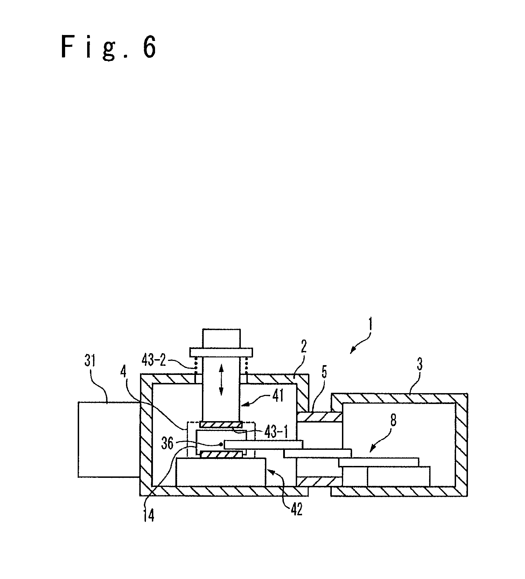

FIG. 6 is another (vertical) sectional view showing the structure of the room-temperature bonding apparatus according to the present embodiment. Moreover, the bonding chamber 2 is provided with an upper-side stage 41 and a lower-side stage 42 thereinside. The upper-side stage 41 is provided with a sample table 43-1 and a pressure bonding mechanism 43-2. The sample table 43-1 is supported to be moveable in a vertical direction to the bonding chamber 2. The sample table 43-1 has a dielectric layer in the lower end, and absorbs or sucks the wafer w to the dielectric layer with electrostatic force by applying a voltage between the dielectric layer and the wafer w. The pressure bonding mechanism 43-2 moves the sample table 43-1 in a direction parallel to the vertical direction to the bonding chamber 2 in response to the operation by the user.

The lower-side stage 42 supports the wafer w or the cartridge 20 or cartridge 21 on which the wafer w is loaded, in its upper end. The lower-side stage 42 is provided with a positioning stage 44, a carriage support table 45, a carriage 46, and an elastic guide 47. Moreover, the lower-side stage 42 is provided with a positioning mechanism (not shown). When the wafer w supported by the upper-side stage 41 and the wafer w supported by the lower-side stage 42 are apart from each other, the high-speed atom beam source 4 is turned to a space between the wafer w supported by the upper-side stage 41 and the wafer w supported by the cartridge 20 or 21 on the lower-side stage 42 and turned to the inner wall surface of the bonding chamber 2. That is, the irradiation direction 36 of the high-speed atom beam source 4 passes through the space between the wafer w supported by the upper-side stage 41 and the wafer w supported by the cartridge 20 or 21 on the lower-side stage 42 and intersects with the inner wall surface of the bonding chamber 2.

Note that although not shown in FIG. 5 and FIG. 6, the bonding chamber 2 is further provided with a configuration of forming the intermediate layer, when the third room-temperature bonding method of FIG. 3C is carried out. Specifically, the bonding chamber 2 is further provided with a lower-side target holding substrate, an upper-side target holding substrate, a lower-side target moving mechanism and an upper-side target moving mechanism. In this case, a lower-side target holding substrate is provided in a location of the lower-side stage 42 on the side of high-speed atom beam source 4 in a horizontal direction. The lower-side target moving mechanism holds the lower-side target holding substrate to be movable in the vertical direction and the horizontal direction, and to be changeable in an orientation to the opening of the high-speed atom beam source 4, and an orientation to the wafer w. The upper-side target holding substrate is provided in a location of the sample table 43-1 which location is on the side of the high-speed atom beam source 4. The upper-side target moving mechanism holds the upper-side target holding substrate to be movable in the vertical direction and the horizontal direction, and to be changeable in an orientation to the opening of the high-speed atom beam source 4, and an orientation to the wafer w. Each target holding substrate can be moved to a position where the high-speed atom beam from the high-speed atom beam source 4 does not intersect an irradiated surface of the target at least, by a corresponding target moving mechanism.

A target is attached to the upper surface of the lower-side target holding substrate and/or the lower surface of the upper-side target holding substrate. The target has a plate-like bulk shape. As a material of the target, an appropriate material is used to form the intermediate layer which assists the bonding of both the wafers w, when bonding the upper-side wafer w and the lower-side wafer w. The material is appropriately selected based on a situation of the surfaces of both the wafers w to be bonded. As the material, a metal material (containing an alloy material), a semiconductor material, an insulating material, a dielectric material, and a magnetic substance material are exemplified.

Next, the operation of the room-temperature bonding apparatus 1 (the room-temperature bonding method) will be described.

When the inside of the bonding chamber 2 is in the vacuum ambient, the conveyance unit 8 sets the wafer w loaded in the first cartridge 20 and the wafer w loaded in the second cartridge 21 from the load lock chamber 3 onto the upper-side stage 41 and the lower-side stage 42, respectively. Next, in the condition that the wafer w on the upper-side stage 41 and the wafer w on the lower-side stage 42 are apart from each other, the high-speed atom beam is irradiated from the high-speed atom beam source 4 into a space between the wafer w on the upper-side stage 41 and the wafer w on the lower-side stage 42. The high-speed atom beam is irradiated to these wafers w to remove oxide and so on formed on the surfaces of these wafers w and to remove impurities adhered to the surfaces of these wafers w (in case of FIG. 3A). Here, in case of FIG. 3B, in addition to the above, one of the wafers w is sputtered so that the adhesion layer formed of the sputtered wafer w is deposited on the bonding surface of the other wafer w. Moreover, in case of FIG. 3C, in addition to the above, the high-speed particle beam is irradiated to the surface of the target to sputter the target, and the material of the target is deposited on the surfaces of both the wafers w.

After that, the sample table 43-1 descends downwardly in the vertical direction by the pressure welding mechanism 43-2 of the upper-side stage 41 and the wafer w of the upper-side stage 41 and the wafer w of the lower-side stage 42 are bonded. Thus, the bonded wafer is formed. When the whole or part of the electronic device and metal wiring lines is previously formed to each wafer w, the room-temperature bonded device is completed in the bonded wafer w through this bonding. That is, the bonded wafer having the room-temperature bonded device is formed. After that, the bonded wafer w is carried out to the load lock chamber 3 by the conveyance unit 8. Next, the bonded wafer w is divided in a predetermined size to form a plurality of the room-temperature bonded devices.

As mentioned above, the operation of the room-temperature bonding apparatus 1 (the room-temperature bonding method) is carried out. Note that in the above-mentioned room-temperature bonding method, heating a substrate is not necessary.

The following examples are exemplified in which the above-mentioned room-temperature bonded device, bonded wafer having the room-temperature bonded devices, and room-temperature bonding method are applied.

### (Example 1)

In the present embodiment, the room-temperature bonded device is formed by using either of a plurality of combinations of the material A and the material B shown in FIG. 4A to FIG. 4C. In this case, the example of the room-temperature bonded device having no cavity (vacuum region) between the bonding substrates will be described.

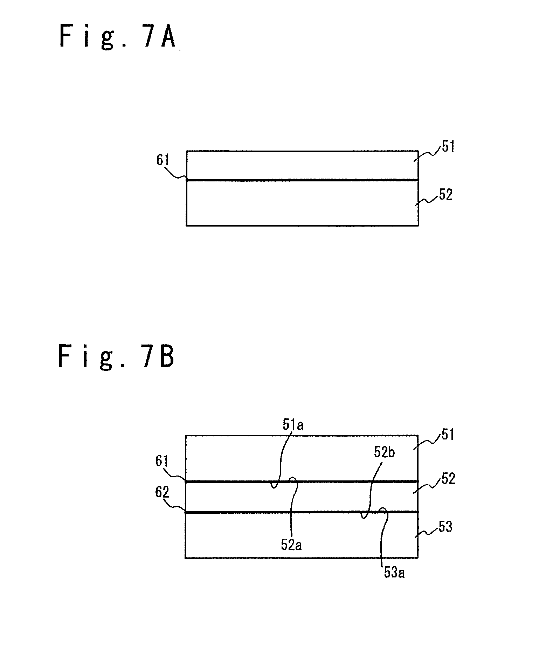

FIG. 7A and FIG. 7B are sectional views showing examples of the room-temperature bonded device in the present embodiment. First, as shown in FIG. 7A, the room-temperature bonded device is formed by the room-temperature-bonding an upper-side substrate 51 and a lower-side substrate 52 (bonding plane 61). Subsequently, as shown in FIG. 7B, a substrate 53 is room-temperature-bonded to the lower-side of the lower-side substrate 51 (bonding plane 62). That is, the surface 52a of the lower-side substrate 52 and the surface 51a of the upper-side substrate 51 are room-temperature-bonded (bonding plane 61). Moreover, the surface 52b of the lower-side substrate 52 which opposes to the surface 52a and the surface 53a of the lower-side substrate 53 are room-temperature-bonded (bonding plane 62). At this time, a relation of the substrate 51 and the substrate 52 may be a relation of the material A and the material B in FIG. 4A to FIG. 4C, and may be a relation of the material B and the material A. Also, the relation of the substrate 52 and the substrate 53 may be the relation of the material A and the material B in FIG. 4A to FIG. 4C, and may be a relation of the material B and the material A.

Such a room-temperature bonded device is a bonded device which is manufactured by room-temperature-bonding any adjacent two of the plurality of substrates or layers. An SOI wafer, a surface acoustic wave device (SAW device), an LED and so on are exemplified as the room-temperature bonded device or substrate which has the similar structure.

In the present embodiment, the bonding is carried out without heating by the room-temperature bonding. As a result, because a warp due to the heating does not occur, it is possible to improve the yield of the room-temperature bonded device. Also, because the heating and cooling time becomes unnecessary, the manufacturing time can be decreased so that it is possible to improve the productivity. Also, because there are many kinds of bonding materials and there are many options, the wide application fields can be used in addition to the above-mentioned example.

### (Example 2)

In the present embodiment, the room-temperature bonded device can be formed by using either of the plurality of combinations of the material A and the material B shown in FIG. 4A to FIG. 4C. In this case, an example of the room-temperature bonded device having a cavity (vacuum region) between the bonding substrates will be described.

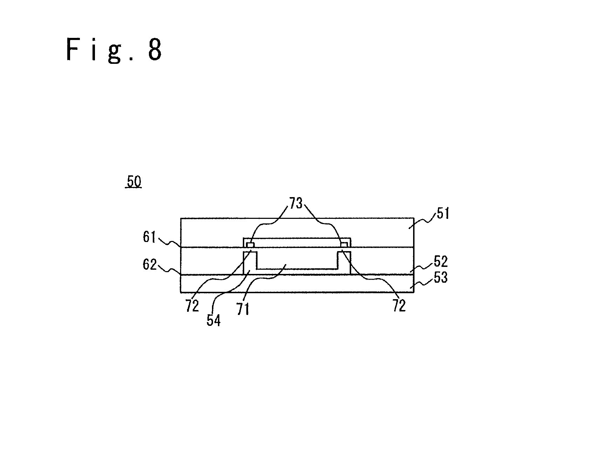

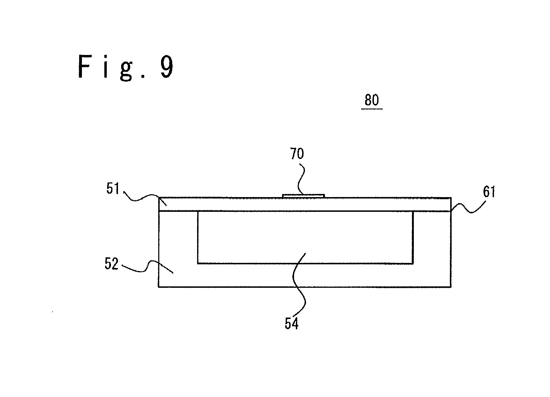

FIG. 8 is a sectional view showing an example of the room-temperature bonded device in the present embodiment. This room-temperature bonded device is an acceleration sensor 50. This acceleration sensor 50 has a structure in which an upper-side substrate 51 (wafer w or material A), an intermediate substrate 52 (wafer w or material B) and a lower-side substrate 53 (wafer w or the material A) are room-temperature-bonded (bonding planes 61, 62). Also, FIG. 9 is a sectional view showing another example of the room-temperature bonded device in the present embodiment. This room-temperature bonded device is a pressure sensor 80. This pressure sensor 80 has a structure in which an upper-side substrate 51 (wafer w or material A) and a lower-side substrate 52 (wafer w or material B) are room-temperature-bonded (bonding plane 61).

Such a room-temperature bonded device (e.g. acceleration sensor 50, pressure sensor 80) contains a miniaturization structure (e.g. weight 71, plate spring 72, piezoelectric resistances 73, 70) in a predetermined space (e.g. cavity 54) of the substrate bonded at the room-temperature. The space is sealed in a vacuum state or a predetermined gas ambience. As the room-temperature bonded device having a similar structure, an RF switch and so on are exemplified.

In the present embodiment, bonding is carried out without a heating process by the room-temperature bonding. As a result, because a warp due to the heating does not occur, it is possible to improve the yield of the room-temperature bonded device. Also, because the heating and cooling time becomes unnecessary, the manufacturing time decreases so that it is possible to improve the productivity. Also, because there are many kinds of materials and wide options to be selected, the application field can be made wide in addition to the above-mentioned example.

In the above embodiments and examples, because the above-mentioned effects can be attained, the room-temperature bonded device (containing MEMS and semiconductor device) can be provided that is formed by carrying out the room-temperature bonding to substrates and wafers to which pre-processing is applied to function as a predetermined device, for the combinations of various materials (e.g. FIG. 4A to FIG. 4C). The high quality device manufacturing method in which the room-temperature bonding is applied for a bonding process of the can be provided in a production process of the room-temperature bonded device (containing MEMS and semiconductor device) of the above-mentioned combination of the materials.

As above, according to the present invention, the bonding can be carried out in various combinations of materials as components of a functional device. Also, the bonding can be carried out without generating any inner stress in the bonding boundary even if it different kinds of materials are used. Moreover, an electronic device and a mechanical device formed in the material in the bonding process can be prevented from being exposed to a high temperature environment. Moreover, MEMS and semiconductor devices can be provided that have bonding structures of various materials, and that are high in the production yield and the operational reliability.

The present invention has been described with reference to the above some embodiments and examples. It is clear to a person skilled in the art that these embodiments and examples are merely provided to show the present invention. These embodiments and examples should not be used to interpret the attached claims to limit the scope of the claims.

The present invention is not limited to the above embodiments and examples and it is clear that each of the embodiments and examples may be changed and modified appropriately in the range of the technical features of the present invention.

This application is based on Japanese Patent Application No. JP 2012-258771 which was filed on November 27, 2012, and claims the profit of the priority of the application. The disclosure thereof is incorporated herein by reference.

## Claims

1. A room-temperature bonded device comprising:
a first substrate having a first surface; and
a second substrate having a second surface that is subjected to a room-temperature bonding with the first surface,
wherein in the bonding of the first surface and the second surface, the first surface contains one material selected from the group consisting of Si, SiO₂, GaN, LiTaO₃, LiNbO₃, Cu, glass, quartz, sapphire, YAG, Al, AlN, Au, Ag, AlCu, C, Cr, GaAs, GaP, Ge, InGaP, Mo, SiC, SiN, SiOC, SiON, Ta, Ti and TiO₂, and
wherein the second surface contains one material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo, YAG, InGaAs, Ga₂O₃, spinel, AlCu, Cr, Ta, ZnO, Ti, RIG, ITO, AuSn, GaP, SiOC, SiON and TiO₂.

2. The room-temperature bonded device according to claim 1, wherein in the bonding of the first surface and the second surface, either of the first surface and the second surface contains an n^{th} one-side material, and the other contains an n^{th} other-side material, and the n is either of integers of 1 to 28,
wherein in case of n = 1, the first one-side material contains Si, and the first other-side material contains the material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo and YAG,
wherein in case of n = 2, the second one-side material contains SiO₂, and the second other-side material contains the material selected from the group consisting of SiO₂, LiNbO₃, sapphire, SiN, glass, quartz, LiTaO₃, Al, C, InGaAs, InP, SiC, YAG, GaN, Ag and MgO,
wherein in case of n = 3, the third one-side material contains GaN, and the third other-side material contains the material selected from the group consisting of AlN, GaN, Ga₂O₃, Mo, SiC, sapphire, spinel, W, SiN and YAG,
wherein in case of n = 4, the fourth one-side material contains LiTaO₃, and the fourth other-side material contains the material selected from the group consisting of sapphire, LiTaO₃, SiN, glass, quartz, LiNbO₃, Cu, ZnO, C and spinel,
wherein in case of n = 5, the fifth one-side material contains LiNbO₃ and the fifth other-side material contains the material selected from the group consisting of LiNbO₃, Au, Ti, glass and quartz,
wherein in case of n = 6, the sixth one-side material contains Cu, and the sixth other-side material contains the material selected from the group consisting of Cu, Al, AlN, SiN, Ti, Au, AlCu, Cr and Ta,
wherein in case of n = 7, the seventh one-side material contains glass or quartz, and the seventh other-side material contains the material selected from the group consisting of glass, quartz, GaAs, RIG, SiN and MgO,
wherein in case of n = 8, the eighth one-side material contains sapphire, and the eighth other-side material contains the material selected from the group consisting of sapphire, YAG, ZnO, RIG and ITO,
wherein in case of n = 9, the ninth one-side material contains YAG and the ninth other-side material contains the material selected from the group consisting of YAG, Al, ITO and ZnO,
wherein in case of n = 10, the tenth one-side material contains Al and the tenth other-side material contains the material selected from the group consisting of Al, AlN and Ge,
wherein in case of n = 11, the eleventh one-side material contains AlN and the eleventh other-side material contains the material selected from the group consisting of AlN, SiC and W,
wherein in case of n = 12, the twelfth one-side material contains Au and the twelfth other-side material contains the material selected from the group consisting of Au, AuSn, InP and Al sapphire,
wherein in case of n = 13, the thirteenth one-side material contains Ag and the thirteenth other-side material contains Ag,
wherein in case of n = 14, the fourteenth one-side material contains AlCu and the fourteenth other-side material contains AlCu,
wherein in case of n = 15, the fifteenth one-side material contains C and the fifteenth other-side material contains C,
wherein in case of n = 16, the sixteenth one-side material contains Cr and the sixteenth other-side material contains Cr,
wherein in case of n = 17, the seventeenth one-side material contains GaAs and the seventeenth other-side material contains GaAs or InP,
wherein in case of n = 18, the eighteenth one-side material contains GaP and the eighteenth other-side material contains GaP,
wherein in case of n = 19, the nineteenth one-side material contains Ge and the nineteenth other-side material contains Ge,
wherein in case of n = 20, the twentieth one-side material contains InGaP and the twentieth other-side material contains InGaP,
wherein in case of n = 21, the twenty-first one-side material contains Mo, and the twenty-first other-side material contains Mo or W,
wherein in case of n = 22, the twenty-second one-side material contains SiC and the twenty-second other-side material contains SiC,
wherein in case of n = 23, the twenty-third one-side material contains SiN and the twenty-third other-side material contains SiN,
wherein in case of n = 24, the twenty-fourth one-side material contains SiOC, and the twenty-forth other-side material contains SiOC,
wherein in case of n = 25, the twenty-fifth one-side material contains SiON, and the twenty-fifth other-side material contains SiON,
wherein in case of n = 26, the twenty-sixth one-side material contains Ta and the twenty-sixth other-side material contains Ta,
wherein in case of n = 27, the twenty-seventh one-side material contains Ti, and the twenty-seventh other-side material contains Ti, and
wherein in case of n = 28, the twenty-eighth one-side material contains TiO₂ and the twenty-eighth other-side material contains TiO₂.

3. The room-temperature bonded device according to claim 2, further comprising a third substrate having a third surface,
wherein the second substrate further has a fourth surface opposite to the second surface and bonded to the third surface, and
wherein in case of bonding of the third surface and the fourth surface, one of the third surface and the fourth surface contains the n^{th} one-side material and the other contains the n^{th} other-side material.

4. A wafer comprising a plurality of the room-temperature bonded devices according to any of claims 1 to 3,
wherein a first wafer is common to the plurality of room-temperature bonded devices and comprises the first substrate of each of the plurality of room-temperature bonded devices,
wherein a second wafer is common to the plurality of room-temperature bonded devices and comprises the second substrate of each of the plurality of room-temperature bonded devices.

5. A room-temperature bonding method comprising:
providing a room-temperature bonding apparatus which comprises:
a vacuum container;
a first holding mechanism disposed in the vacuum container;
a second holding mechanism disposed in the vacuum container;
a beam source disposed in the vacuum container to emit an activation beam; and
a pressure bonding mechanism disposed in the vacuum container;
holding a first substrate by a first holding mechanism and a second substrate by the second holding mechanism;
irradiating the activation beam from the beam source to bonding surfaces of the first substrate and the second substrate; and
bonding the first substrate and the second substrate by facing the bonding surfaces of the first substrate and the second substrate which are irradiated with the activation beam by the pressure bonding mechanism;
wherein the first substrate has a first surface, and the second substrate has a second surface to be bonded to the first surface,
wherein in the bonding of the first surface and the second surface, the first surface contains one material selected from the group consisting of Si, SiO₂, GaN, LiTaO₃, LiNbO₃, Cu, glass, quartz, sapphire, YAG, Al, AlN, Au, Ag, AlCu, C, Cr, GaAs, GaP, Ge, InGaP, Mo, SiC, SiN, SiOC, SiON, Ta, Ti and TiO₂,
wherein the second surface contains one material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo, YAG, InGaAs, Ga₂O₃, spinel, AlCu, Cr, Ta, ZnO, Ti, RIG, ITO, AuSn, GaP, SiOC, SiON and TiO₂.

6. The room-temperature bonding method according to claim 5, wherein in the bonding of the first surface and the second surface, one of the first surface and the second surface contains an n^{th} one-side material and the other contains an n^{th} other-side material, and n is either of integers of 1 to 28,
wherein in case of n = 1, the first one-side material contains Si, the first other-side material contains the material selected from the group consisting of Si, SiO₂, glass, quartz, Au, LiTaO₃, sapphire, GaN, GaAs, LiNbO₃, SiN, InP, Cu, SiC, Ag, Al, AlN, Ge, La, MgO, Pt, Ru, W, C, Ni, Mo and YAG,
wherein in case of n = 2, the second one-side material contains SiO₂, and the second other-side material contains the material selected from the group consisting of SiO₂, LiNbO₃, sapphire, SiN, glass, quartz, LiTaO₃, Al, C, InGaAs, InP, SiC, YAG, GaN, Ag and MgO,
wherein in case of n = 3, the third one-side material contains GaN and the third other-side material contains the material selected from the group consisting of AlN, GaN, Ga₂O₃, Mo, SiC, sapphire, the spinel, W, SiN and YAG,
wherein in case of n = 4, the fourth one-side material contains LiTaO₃ and the fourth other-side material contains the material selected from the group consisting of sapphire, LiTaO₃, SiN, glass, quartz, LiNbO₃, Cu, ZnO, C and spinel,
wherein in case of n = 5, the fifth one-side material contains LiNbO₃ and the fifth other-side material contains the material selected from the group consisting of LiNbO₃, Au, Ti, glass and quartz,
wherein in case of n = 6, the sixth one-side material contains Cu, and the sixth other-side material contains the material selected from the group consisting of Cu, Al, AlN, SiN, Ti, Au, AlCu, Cr and Ta,
wherein in case of n = 7, the seventh one-side material contains glass or quartz and the seventh other-side material contains the material selected from the group consisting of glass, quartz, GaAs, RIG, SiN and MgO,
wherein in case of n = 8, the eighth one-side material contains sapphire, and the eighth other-side material contains the material selected from the group consisting of sapphire, YAG, ZnO, RIG and ITO,
wherein in case of n = 9, the ninth one-side material contains YAG and the ninth other-side material contains the material selected from the group consisting of YAG, Al, ITO and ZnO,
wherein in case of n = 10, the tenth one-side material contains Al and the tenth other-side material contains the material selected from the group consisting of Al, AlN and Ge,
wherein in case of n = 11, the eleventh one-side material contains AlN and the eleventh other-side material contains the material selected from the group consisting of AlN, SiC and W,
wherein in case of n = 12, the twelfth one-side material contains Au and the twelfth other-side material contains the material selected from the group consisting of Au, AuSn, InP and Al sapphire,
wherein in case of n = 13, the thirteenth one-side material contains Ag and the thirteenth other-side material contains Ag,
wherein in case of n = 14, the fourteenth one-side material contains AlCu and the fourteenth other-side material contains AlCu,
wherein in case of n = 15, the fifteenth one-side material contains C and the fifteenth other-side material contains C,
wherein in case of n = 16, the sixteenth one-side material contains Cr and the sixteenth other-side material contains Cr,
wherein in case of n = 17, the seventeenth one-side material contains GaAs and the seventeenth other-side material contains GaAs or InP,
wherein in case of n = 18, the eighteenth one-side material contains GaP and the eighteenth other-side material contains GaP,
wherein in case of n = 19, the nineteenth one-side material contains Ge and the nineteenth other-side material contains Ge,
wherein in case of n = 20, the twentieth one-side material contains InGaP and the twentieth other-side material contains InGaP,
wherein in case of n = 21, the twenty-first one-side material contains Mo and the twenty-first other-side material contains Mo or W,
wherein in case of n = 22, the twenty-second one-side material contains SiC and the twenty-second other-side material contains SiC,
wherein in case of n = 23, the twenty-third one-side material contains SiN and the twenty-third other-side material contains SiN,
wherein in case of n = 24, the twenty-fourth one-side material contains SiOC and the twenty-fourth other-side material contains SiOC,
wherein in case of n = 25, the twenty-fifth one-side material contains SiON and the twenty-fifth other-side material contains SiON,
wherein in case of n = 26, the twenty-sixth one-side material contains Ta and the twenty-sixth other-side material contains Ta,
wherein in case of n = 27, the twenty-seventh one-side material contains Ti and the twenty-seventh other-side material contains Ti,
wherein in case of n = 28, the twenty-eighth one-side material contains TiO₂ and the twenty-eighth other-side material contains TiO₂.
